(19) Europäisches Patentamt
European Patent Office
Office européen des brevets

(11) **EP 3 676 625 B1**

(12) **EUROPEAN PATENT SPECIFICATION**

(45) Date of publication and mention
of the grant of the patent:
**09.08.2023  Bulletin 2023/32**

(21) Application number: **18870616.2**

(22) Date of filing: **25.10.2018**

(51) International Patent Classification (IPC):
**G01R 31/36** *(2020.01)*     **B60L 50/50** *(2019.01)*

(52) Cooperative Patent Classification (CPC):
**G01R 31/3648; G01R 31/367; G01R 31/392;
H01M 10/42; H01M 10/482; H01M 10/486;**
Y02E 60/10; Y02E 60/50; Y02T 10/70

(86) International application number:
**PCT/KR2018/012728**

(87) International publication number:
**WO 2019/083300 (02.05.2019 Gazette 2019/18)**

(54) **APPARATUS AND METHODS FOR IDENTIFYING ANOMALY(IES) IN RE-CHARGEABLE BATTERY OF EQUIPMENT AND CONNECTED COMPONENT(S)**

VORRICHTUNG UND VERFAHREN ZUR IDENTIFIZIERUNG VON ANOMALIEN BEI EINER WIEDERAUFLADBAREN BATTERIE VON GERÄTEN UND ANGESCHLOSSENEN KOMPONENTEN

APPAREIL ET PROCÉDÉS POUR IDENTIFIER UNE OU DES ANOMALIES DANS UNE BATTERIE RECHARGEABLE D'ÉQUIPEMENT ET COMPOSANT(S) CONNECTÉ(S)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.10.2017  IN 201741037852
24.07.2018  IN 201741037852**

(43) Date of publication of application:
**08.07.2020  Bulletin 2020/28**

(73) Proprietor: **Samsung Electronics Co., Ltd.
Suwon-si, Gyeonggi-do 16677 (KR)**

(72) Inventors:
• **NAHA, Arunava**
  **Bangalore 560037 (IN)**
• **KHANDELWAL, Ashish**
  **Bangalore 560037 (IN)**
• **YADU, Ankit**
  **Bangalore 560037 (IN)**
• **HARIHARAN, Krishnan S**
  **Bangalore 560037 (IN)**
• **GEORGE, Anjith**
  **Bangalore 560037 (IN)**
• **PARAMASIVAM, Periyasamy**
  **Bangalore 560037 (IN)**

(74) Representative: **Nederlandsch Octrooibureau
P.O. Box 29720
2502 LS The Hague (NL)**

(56) References cited:
WO-A1-2017/006319      CN-A- 104 614 630
CN-B- 102 350 951       JP-A- 2004 222 176
KR-A- 20060 027 164     KR-A- 20110 077 194
KR-A- 20160 134 551     US-A1- 2008 312 852
US-A1- 2009 306 841     US-A1- 2012 123 712
US-A1- 2012 206 107     US-A1- 2016 161 542
US-A1- 2016 231 388     US-A1- 2017 227 610
US-B1- 8 855 954

## Description

### Technical Field

The present disclosure relates to the field of battery management systems, and more particularly to apparatus and methods for identification of anomalies in batteries of an equipment and loads or components connected to the re-chargeable battery.

This application based on and claims priority under 35 U.S.C. § 119 to Indian Provisional Patent Application No. 201741037852, filed on October 25, 2017, and Indian Complete Patent Application No. 201741037852, filed on July 24, 2018, in the Indian Patent Office.

### Background Art

In general, a re-chargeable battery and the connected loads/components present in a device/equipment may become faulty due to reasons such as internal short circuits, mechanical abuse (i.e. dropping the re-chargeable battery or device), electrical abuse (i.e. overcharging, over discharging and external short circuit), and so on. Such faults may cause thermal runaway, which can be a threat to human safety and may also cause financial losses to the user and the manufacturer.

Accordingly, the re-chargeable battery may be repeatedly charged and discharged during operations of the electronic device. As the number of times the re-chargeable battery is discharged and charged increases, the capacity of the battery gradually decreases. Further, decrease in the re-chargeable battery capacity, power, operation time, and stability of corresponding electronic devices may be compromised. Conventionally, the expected time for battery replacement, a State Of Health (SoH) of the battery may be estimated. The conventional battery state estimation method may determine a validity of a battery model, which may be dependent on a parameter, based on state information of a battery that is estimated from battery information of the battery.

However, conventional estimation methods do not contemplate detecting internal battery fault. Conventional estimation methods also do not identify the fault based on estimating multiple features related to voltage and current of the re-chargeable battery and connected loads/components. Furthermore, conventional methods do not contemplate identifying an anomaly in both battery and connected loads/components in electronic device and vehicles. Relevant examples of approaches for detecting anomalies in a rechargeable battery or in a component connected to said battery are disclosed in KR 2016 0134551 A, CN 102 350 951 B, US 2016/231388 A1, US 2016/161542 A1, US 2012/206107 A1.

### Disclosure of Invention

### Technical Problem

The disclosure relates to identifying at least one anomaly in at least one of a re-chargeable battery of an equipment and loads/components connected to the re-chargeable battery.

According to an aspect of the disclosure, there are provided apparatuses and methods for identifying anomalies in the re-chargeable battery of the equipment and the connected loads/components using only current and voltage measurements during the regular operation of the re-chargeable battery.

According to an aspect of the disclosure, there are provided methods and systems for detecting severity of anomalies in the battery of the equipment and the connected loads present in the device using only current and voltage measurements during the regular operation of the battery.

According to an aspect of the disclosure, there are provided apparatuses and methods for outputting suggestion data to a user to perform upon identifying at least one anomaly in at least one of the re-chargeable battery or loads/components connected to the re-chargeable battery.

According to an aspect of the disclosure, there are provided apparatuses and methods for determining a plurality of features based on the derived current and voltage parameters.

### Solution to Problem

The invention is defined by a method according to claim 1 and the associated apparatus according to claim 11. Further embodiments are defined by the corresponding dependent claims.

### Brief Description of Drawings

The above and other aspects, features, and advantages of certain embodiments of the disclosure will be more apparent from the following description taken in conjunction with the accompanying drawings, in which:

FIG. 1 illustrates a block diagram of an apparatus for identifying an anomaly in at least one of a re-chargeable battery of an equipment and at least one component connected to the re-chargeable battery, according to an embodiment;

FIG. 2 illustrates a detailed view of a processing module as shown in FIG. 1, comprising various modules, according to an embodiment;

FIG. 3 illustrates a flowchart for estimating mean of internal resistance during discharge (meanR) of the re-chargeable battery of the equipment, and a difference of end of charge resistance and start of discharge (ΔR) of the re-chargeable battery, according to an embodiment;

FIG. 4 illustrates a flowchart of the method for displaying the status of the at least one of the re-chargeable battery of the equipment and at least one component connected to the re-chargeable battery, according to an embodiment;

FIG. 5A illustrates a use case scenario of severe fault is identified in the at least one of the re-chargeable battery of the equipment and the at least one component connected to the re-chargeable battery, according to an embodiment;

FIG. 5B illustrates a use case scenario, in which a fault with low severity is identified in the re-chargeable battery of the equipment and/or the components connected to the re-chargeable battery(s), according to an embodiment;

FIG. 5C illustrates a use case scenario in which an incipient fault is identified in the re-chargeable battery of the equipment and/or the components connected to the re-chargeable battery(s), according to an embodiment;

FIG. 5D illustrates a use case scenario where a fault is detected using a server, in the re-chargeable battery of the equipment and/or the components connected to the re-chargeable battery(s), according to an embodiment;

FIG. 6A illustrates a use case scenario to detect moderate abuse of the re-chargeable battery of the equipment and/or the components connected to the re-chargeable battery(s), according to an embodiment;

FIG. 6B illustrates a use case scenario in which a severe short circuit is detected in the re-chargeable battery of the equipment and/or the components connected to the re-chargeable battery(s), according to an embodiment;

FIG. 7A illustrates a flowchart of a method for identifying an anomaly in at least one of the re-chargeable battery of the equipment and at least one component connected to the re-chargeable battery of the equipment, according to an embodiment;

FIG. 7B illustrates a flowchart of a method for triggering to turn off the equipment or the host device, according to an embodiment;

FIG. 7C illustrates a flowchart of a method for creating a training model associated with the learned data corresponding to the plurality of the characteristic data, according to an embodiment;

FIG. 7D illustrates a flowchart of a method for outputting at least one suggestion data based on identified severity level of the fault, according to an embodiment; and

FIG. 8 is a system for identifying an anomaly in at least one of the re-chargeable battery of the equipment and at least one component connected to the re-chargeable battery of the equipment, according to an embodiment.

## Mode for the Invention

The embodiments herein and the various features and advantageous details thereof are explained more fully with reference to the accompanying drawings and detailed in the following description. Descriptions of well-known components and processing techniques are omitted to not unnecessarily obscure the embodiments herein. The description herein is intended merely to facilitate an understanding of ways in which the embodiments herein can be practiced and to further enable those of skill in the art to practice the embodiments herein. Accordingly, this disclosure should not be construed as limiting the scope of the embodiments herein.

Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

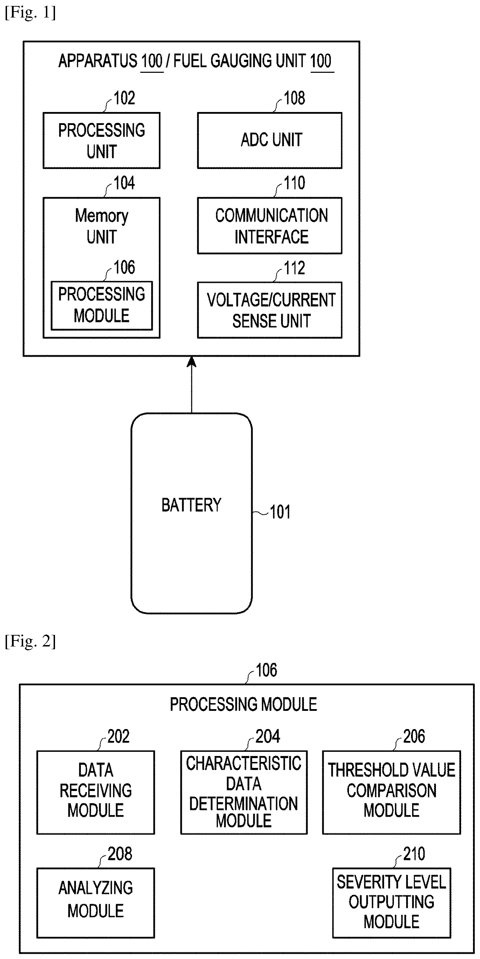

The embodiments herein achieve an apparatus and method for identifying at least one anomaly in at least one of a re-chargeable battery of an equipment or loads/ components connected to the re-chargeable battery. Referring now to the drawings, and more particularly to FIGS. 1 through 7, in which similar reference characters denote corresponding features consistently throughout the figures, there are shown embodiments.

FIG. 1 illustrates a block diagram of an apparatus for identifying an anomaly in at least one of a re-chargeable battery 101 of an equipment and at least one component connected to the re-chargeable battery 101, according to an embodiment.

The apparatus 100 includes a processing unit 102, a memory unit 104, an Analog to Digital Conversion (ADC) unit 108, a communication interface 110, a voltage/current sense unit 112. Further, the apparatus 100 may include a processing module 106. When the machine readable instructions are executed, the processing module 106 causes the apparatus 100 to process the data using the processing unit 102. Furthermore, the memory unit 104 may also include a cache, flash, disk, or other memory to store the required data. The apparatus 100 may also retrieve the data from the external databases based on the requirement and store the retrieved data in the memory unit 104 associated with the apparatus 100. The apparatus 100 is communicatively coupled to the at least one of the re-chargeable battery 101 of the equipment.

The voltage/current sense unit 112 is configured to measure the input/output voltage/ current instantaneous data with reference voltage/current, from the at least one of the re-chargeable battery 101 of the equipment and at least one component connected to the re-chargeable. The ADC unit 108 is configured to convert the measured analog input/output voltage/current instantaneous data to digital input/output voltage/current instantaneous data.

The processing unit 102 may process the data. Alternatively, the apparatus 100 may transmit the data to a communicatively coupled processor residing in the at least one host device or server. Examples, of the processing unit 102 and the processor, can be at least one of, but not limited to, an application processor, an algorithm processor, a dedicated processor, a microprocessor, a control unit, and so on. The host device equipment can be at least one of, but not limited to, an electronic device, a server, a vehicle infotainment system, a vehicle, and so on. The equipment can be at least one of, but not limited to, an electronic device, a server, a vehicle infotainment system, a vehicle, and so on.

Further, the apparatus 100 can also be a fuel gauging unit 100. The apparatus 100 can reside in at least one of, but not limited to, a mobile phone, a smart phone, a tablet, a handheld device, a phablet, a laptop, a computer, a wearable computing device, a server, a host device, a vehicle infotainment system, an electric vehicle, a motor vehicle, and so on. The apparatus 100 may periodically connect to the server via a communication network. The communication network may be accessible via wired (such as a local area network, Ethernet, and so on) or wireless communication (such as Wi-Fi, Bluetooth, and so on).

The processing module 106 may include modules and sub modules to execute the operation for identifying the anomaly in at least one of the re-chargeable battery 101 of the equipment and least one connected loads/components. The components connected to the re-chargeable battery 101 or loads connected to the re-chargeable battery 101, can be at least one of, but not limited to, a parallel battery, a secondary battery, a series circuit, a parallel circuit, and so on.

In an embodiment, the apparatus 100 is configured to receive parametric measurement data from at least one of the re-chargeable battery 101 of the equipment and at least one component connected to the re-chargeable battery 101. In an embodiment, the parametric measurement data includes at least one of current measurement data, voltage measurement data, and temperature measurement data. In an embodiment, the apparatus 100 is configured to determine a plurality of characteristic data based on the received at least one parametric measurement data. In an embodiment, the plurality of characteristic data includes at least one of, a loss of energy ($E_L$) between charging and discharging of re-chargeable battery 101 of the equipment, a terminal voltage ($V_t$) at fixed low State Of Charge (SOC) (5%) level ($V_{min}$) of re-chargeable battery 101 of the equipment, a Constant Voltage (CV) phase time ($T_{CV}$), a discharge voltage slope (Slope$_v$), a maximum value of SOC at the end of charging (SOC$_m$) of re-chargeable battery 101 of the equipment, a first order slope parameter from the $V_t$ vs. SOC Polynomial curve fitting (polyfit) parameters ($P_{param}$), a mean of estimated internal resistance during discharge (meanR) of the re-chargeable battery 101 of the equipment, and a difference of end of charge resistance and start of discharge ($\Delta R$) of the re-chargeable battery 101 of the equipment.

In an embodiment, the apparatus 100 is configured to compare a plurality of threshold values of the determined plurality of the characteristic data with a data stored in a memory unit 104. Or, the apparatus 100 is configured to compare the determined plurality of the characteristic data with a plurality of threshold values (pre-determined threshold values) stored in a memory unit 104.

In an embodiment, the apparatus 100 is configured to analyze the compared plurality of the threshold values of the determined plurality of the characteristic data. Or, the apparatus 100 is configured to analyze results of comparing the plurality of the threshold values with the plurality of characteristic data.

In an embodiment, the apparatus 100 is configured to output a severity level of the anomaly in the at least one of the re-chargeable battery 101 of the equipment and at least one component connected to the re-chargeable battery 101, based on analyzed plurality of the threshold values of the determined plurality of the characteristic data. Or, the apparatus 100 is configured to output a severity level of the anomaly in the at least one of the re-chargeable battery 101 of the equipment and at least one component connected to the re-chargeable battery 101, based on results of comparing the plurality of the threshold values with the plurality of characteristic data. The severity level of anomaly comprises, for example, at least one of, a negligent level, a medium level, a critical level, and so on.

In an embodiment, the apparatus 100 is further configured to detect a fault in at least one of, the re-chargeable battery 101 of the equipment, the components connected to the re-chargeable battery 101, and equipment, based on determining an abnormality in the received parametric measurement data. In an embodiment, determining the abnormality of the parametric measurement data includes analyzing a behavior pattern of the at least one of the re-chargeable battery 101 of the equipment and the at least one component connected to the re-chargeable battery 101, based on determined at least one of, a drawing abnormal current, an abnormal power demand, an abnormal operation and a short circuit resistance. In an embodiment, the apparatus 100 is further configured to trigger to turn off the equipment based on detecting at least one of the faults and the severity level in at least one of, the re-chargeable battery 101 of the equipment, the components and the equipment.

In an embodiment, the apparatus 100 is further configured to determine a plurality of characteristic data based on the received parametric measurement data. In an embodiment, the apparatus 100 is further configured to analyze a normal operation range of the at least one of the re-chargeable battery 101 of the equipment and the at least one component connected to the re-chargeable battery 101, based on receiving plurality of the characteristic data in initial cycles. In an embodiment, the apparatus 100 is further configured to calculate a Probability Density Function (PDF) for plurality of the characteristic data. In an embodiment, the apparatus 100 is further configured to segregate (or classify) plurality of the characteristic data, based on a statistical classification method. In an embodiment, the apparatus 100 is further configured to create a training model associated with the learned data corresponding to the segregated (or, the classified) plurality of the characteristic data.

In an embodiment, the apparatus 100 is further configured to identify a severity level of the fault in at least one of the re-chargeable battery 101 of the equipment, the components and the equipment. In an embodiment, the apparatus 100 is further configured to output at least one suggestion data based on identified severity level of the fault, and outputting the at least one suggestion data comprises at least one of, a notification to visit service center, a notification to connect the equipment to specific adapter, and a notification to turn off the equipment.

In an embodiment, outputting the at least one suggestion data based on identified severity level of the fault includes storing a log data associated with the severity level of fault. In an embodiment, storing the log data associated with the severity level of the fault further includes transmitting the log data to a server for identification of faulty batch of re-chargeable batteries.

In an embodiment, analyzing the plurality of the compared threshold values of the determined plurality of the characteristic data comprises identifying at least one of, an increase in the threshold value, a decrease in the threshold value, and a similarity in the threshold value, corresponding to the determined plurality of the characteristic data. Or, analyzing the results of the comparing the plurality of the pre-determined threshold values with the plurality of the characteristic data comprises identifying at least one of an increase in a value of the characteristic data, a decrease in a value of the characteristic data, and a similarity in a value of the characteristic data.

In an embodiment, outputting the anomaly associated with the at least one of the re-chargeable battery 101 of the equipment and the at least one component connected to the re-chargeable battery 101, in response to increase in the analyzed threshold value of at least one of, the $E_L$, the $T_{CV}$, the $Slope_v$, the $P_{param}$, and the $SOC_m$. Or, outputting the anomaly associated with the at least one of the re-chargeable battery and the at least one component connected to the re-chargeable battery comprises outputting the anomaly if a value of at least one of, the $E_L$, the $T_{CV}$, the $Slope_v$, the $P_{param}$, and the $SOC_m$ is increased above the pre-determined threshold value.

In an embodiment, outputting the anomaly associated with the at least one of the re-chargeable battery 101 of the equipment and the at least one component connected to the re-chargeable battery 101, in response to decrease in the analyzed threshold value of at least one of, the $V_{min}$, the meanR, and the $\Delta R$. Or, outputting the anomaly associated with the at least one of the re-chargeable battery of the equipment and the at least one component connected to the re-chargeable battery comprises outputting the anomaly if a value of at least one of, the $V_{min}$, the meanR, and the $\Delta R$ is decreased below the pre-determined threshold value.

In an embodiment, outputting the severity level comprises determining, using likelihood estimation method, a likelihood of being faulty corresponding to the at least one of the re-chargeable battery 101 of the equipment, based on a health status of the at least one of the re-chargeable battery 101 of the equipment.

The diagram of FIG. 1 illustrates functional components of the computer implemented system. In some cases, the components may be a hardware component, a software component, or a combination of hardware and software. Some of the components may be application level software, while other components may be operating system level software and services. In some cases, the connection of one component to another may be a close connection in which two or more components are operating on a single hardware platform. In other cases, the connections may be made over network connections spanning long distances. Each embodiment may use different hardware, software, and interconnection architectures to achieve the functions described.

FIG. 2 illustrates a detailed view of a processing module 106 as shown in FIG. 1, comprising various modules, according to an embodiment. The processing module 106 may comprise sub modules such as a data receiving module 202, a characteristic data determination module 204, a threshold value comparison module 206, an analyzing module 208, and a severity level outputting module 210.

In an embodiment, the data receiving module 202 is configured to receive a parametric measurement data from at least one of the re-chargeable battery 101 of the equipment and at least one component connected to the re-chargeable battery 101. In an embodiment, the parametric measurement data includes at least one of current measurement data, voltage measurement data, and temperature measurement data. In an embodiment, the characteristic data determination module 204 is configured to determine a plurality of characteristic data based on the received at least one parametric measurement data. In an embodiment, the plurality of characteristic data includes at least one of, a loss of energy ($E_L$) between charging and discharging of re-chargeable battery 101 of the equipment, a terminal voltage ($V_t$) at

fixed low State Of Charge (SOC) (5%) level ($V_{min}$) of re-chargeable battery 101 of the equipment, a Constant Voltage (CV) phase time ($T_{CV}$), a discharge voltage slope ($Slope_v$), a maximum value of SOC at the end of charging ($SOC_m$) of the re-chargeable battery 101 of the equipment, a first order slope parameter from the $V_t$ vs. SOC Polynomial curve fitting (polyfit) parameters ($P_{param}$), a mean of estimated internal resistance during discharge (meanR) of the re-chargeable battery 101 of the equipment, and a difference of end of charge resistance and start of discharge ($\Delta R$) of the re-chargeable battery 101 of the equipment.

In an embodiment, the threshold value comparison module 206 is configured to compare a plurality of threshold values of the determined plurality of the characteristic data with a data stored in a memory unit 104. Or, the threshold value comparison module 206 is configured to compare the determined plurality of the characteristic data with a plurality of threshold values (pre-determined threshold values) stored in a memory unit 104.

In an embodiment, the analyzing module 208 is configured to analyze the compared plurality of the threshold values of the determined plurality of the characteristic data. Or, the analyzing module 208 is configured to analyze results of comparing the plurality of the threshold values with the plurality of characteristic data.

In an embodiment, the severity level outputting module 210 is configured to output a severity level of the anomaly in the at least one of the re-chargeable battery 101 of the equipment and at least one component connected to the re-chargeable battery 101, based on analyzed plurality of the threshold values of the determined plurality of the characteristic data. Or, the severity level outputting module 210 is configured to output a severity level of the anomaly in the at least one of the re-chargeable battery 101 of the equipment and at least one component connected to the re-chargeable battery 101, based on results of comparing the plurality of the threshold values with the plurality of characteristic data. The severity level of anomaly comprises, for example, at least one of, a negligent level, a medium level, a critical level, and so on.

In an embodiment, the loss of energy ($E_L$) between charging and discharging the re-chargeable battery 101 of the equipment is determined by Equation 1:

$$E_{L=}\frac{Vt}{It} \rightarrow \left(\textstyle\sum Vt\, It\ during\ charging\right) - \left(\textstyle\sum Vt\, It\ during\ discharging\right)$$

In an embodiment, the terminal voltage ($V_t$) at fixed low State Of Charge (SOC) (5%) level ($V_{min}$) of the re-chargeable battery 101 of the equipment is determined by

Equation 2:

$$Vt \rightarrow (find\ terminal\ voltage\ at\ 5\%\ SOC) \rightarrow V_{min}$$

In an embodiment, the Constant Voltage (CV) phase time ($T_{CV}$) is determined by

Equation 3:

$$Vt \rightarrow (find\ time\ taken\ to\ complete\ CV\ phase) \rightarrow T_{CV}$$

In an embodiment, the discharge voltage slope ($Slope_v$) may be:

$$\frac{Vt}{It} \rightarrow \frac{Vt(m) - Vt(n)}{\int_m^n It\, dt} \rightarrow Slope_v$$

where; n: end of discharge, m; near end of discharge point

In an embodiment, the maximum value of SOC at the end of charging ($SOC_m$) of re-chargeable battery 101 of the equipment is determined by Equation 4:

$$It \rightarrow SOC = \int It\ dt\ of\ charge \rightarrow maximum\ of\ SOC \rightarrow SOC_m$$

In an embodiment, the first order slope parameter from the $V_t$ vs. SOC Polynomial curve fitting (polyfit) parameters ($P_{param}$) is determined by Equation 5:

$$It \rightarrow SOC = \int It\ dt\ for\ dicharge$$

$$\rightarrow (Vt \rightarrow polyfit, Vt = a_0 + a_1 SOC^1 + \cdots + a_5 SOC^5) \rightarrow P_{param}$$

$$= a_1$$

The embodiments herein can be embodied by hardware and software elements. The embodiments that are implemented in software include but are not limited to, firmware, resident software, microcode, etc. The functions performed by various modules described herein may be implemented in other modules or combinations of other modules. For the purposes of this description, a computer-usable or computer readable medium can be any apparatus that can comprise, store, communicate, propagate, or transport the program for use by or in connection with the instruction execution system, apparatus, or device.

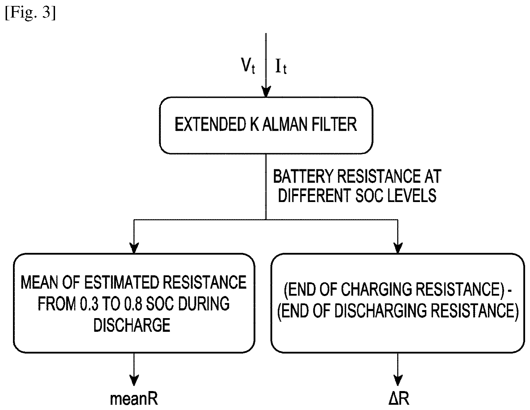

FIG. 3 illustrates a flowchart for estimating mean of internal resistance during discharge (meanR) of the re-chargeable battery 101 of the equipment, and a difference of end of charge resistance and start of discharge (ΔR) of the re-chargeable battery 101 of the equipment, according to an embodiment.

In an embodiment, the mean of estimated internal resistance during discharge (meanR) of the re-chargeable battery 101 of the equipment, and a difference of end of charge resistance and start of discharge (ΔR) of the re-chargeable battery 101 of the equipment are determined by inputting the voltage data and current data to the extended Kalman filter method. The extended Kalman filter method may output the re-chargeable battery 101 of the equipment resistance at different State Of charge (SOC) levels. The data related to the re-chargeable battery 101 of the equipment resistance at different State Of charge (SOC) levels may be further processed to calculate meanR and ΔR. The meanR is determined by estimating the mean of the re-chargeable battery 101 of the equipment resistance from the range of SOC such as 0.3 to 0.8 SOC during discharge of the re-chargeable battery 101 of the equipment. The ΔR may be determined by subtracting the value of end of charging resistance with the end of discharging resistance.

In an embodiment the likelihood (LHi) of features or characteristic data is determined by Equation 6:

$$LH_i = \exp\left(-\frac{(fval_i - \mu_i)^2}{2\sigma_i^2}\right)$$

in which, the 'i' indicates 'i-th' feature, 'fval$_i$' is value of 'i-th' feature, '$\mu_i$' and '$\sigma_i$' are the healthy mean and variance of the same feature respectively.

The Probability Density Function (PDF) of the features is defined by the respective mean and variance of the features.

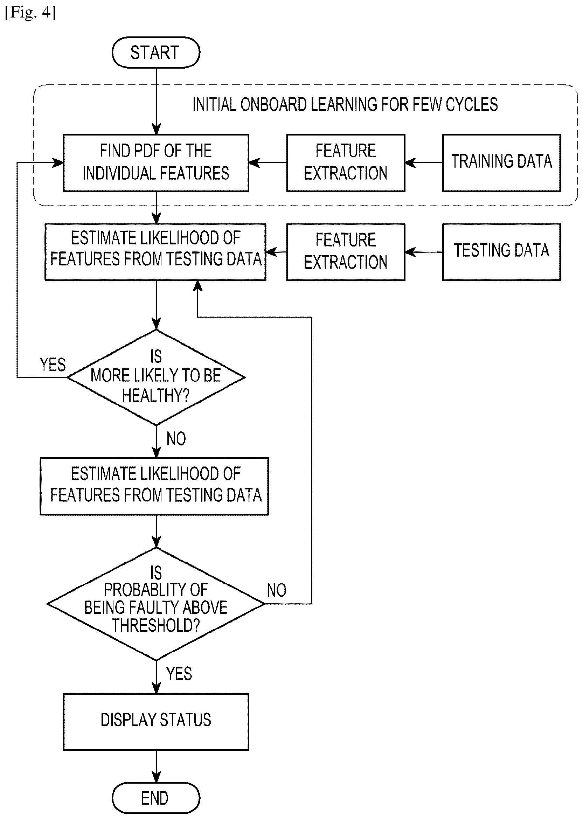

FIG. 4 illustrates a flowchart of the method for displaying the status of the at least one of the re-chargeable battery 101 of the equipment and at least one component connected to the re-chargeable battery 101, according to an embodiment.

In an example, the apparatus 100 is configured to create a model of the learned data based on an input of training data. The training data may include initial cycle of the parametric measurement data received by the apparatus 100 from the re-chargeable battery 101 of the equipment and at least one component. The features or the plurality of the characteristic data may be extracted based on the received parametric measurement data. The parametric measurement data can be voltage data, current data and temperature data. The features can be extracted by mathematical calculation and mathematical derivation based on the input of the parametric measurement data. Further, the Probability Density Function (PDF) is determined for each individual feature. Accordingly, the testing data after initial cycles is received by the apparatus 100 from the re-chargeable battery 101 of the equipment and the at least one component. The features or the plurality of the characteristic data are extracted based on the received parametric measurement data. The likelihood estimation of fault is determined based on comparing the testing data with the training data. Further, if the at least one of the re-chargeable battery 101 of the equipment and the at least one component is healthy, the apparatus 100 may again determine the PDF of individual features. If the at least one of the re-chargeable battery 101 of the equipment and the at least one component is not healthy, the likelihood of a fault is determined. The threshold value of probability of a fault is determined based on determining the likelihood of being faulty. If the threshold value of probability of being faulty is below the threshold, then the likelihood estimation of fault is further determined. If the threshold value of probability of a fault is above the threshold, then the status is displayed on the display unit of the host device or another output (audio, video, haptic, *etc.*) indicative of fault is provided.

The re-chargeable battery 101 of the equipment internal short circuits may be determined based on inferior manufacturing process, re-chargeable battery 101 operation under demanding situation, and so on. The re-chargeable battery 101 of the equipment condition assessment is performed by the apparatus 100 based on determining the abuse and health of the re-chargeable battery 101 of the equipment. The abuse to the re-chargeable battery 101 of the equipment can be at least one of, but not limited to, mechanical abuse due to dropping of host device or equipment, bent host device, constraint due to the re-chargeable battery 101 of the equipment expansion and so on. The health status can be determined by using the re-chargeable battery 101 of the equipment health estimation method. The host device or equipment damage can be determined based on short circuit of the sub components and drawing of abnormal current. The components connected to the re-chargeable battery 101 damage can be determined based on abnormal power demand.

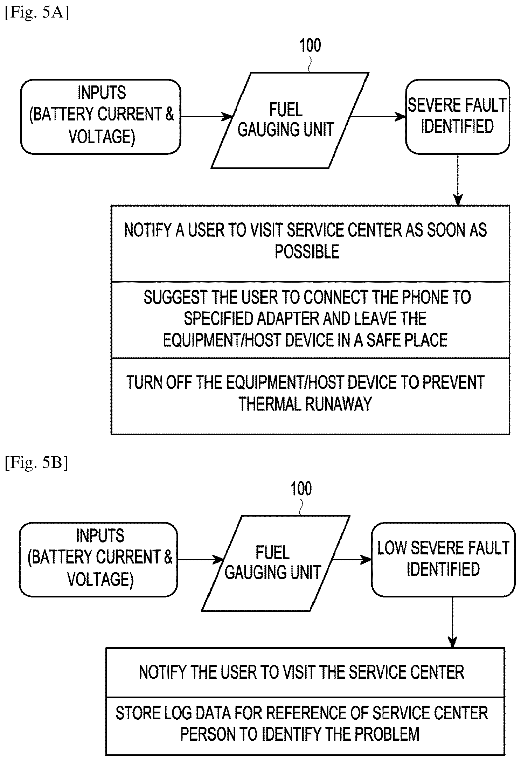

FIG. 5A illustrates a use case scenario of severe fault is identified in the at least one of the re-chargeable battery 101 of the equipment and the at least one component connected to the re-chargeable battery 101 of the equipment, according to an embodiment.

In an example, the apparatus 100 is configured to identify a fault in the at least one of the re-chargeable battery 101 of the equipment and the at least one component connected to the re-chargeable battery 101. The apparatus 100 may notify a user to visit a service center as soon as possible if the fault is severe. The apparatus 100 may output suggestion information to the user to connect the phone to specified adapter and leave the equipment in a safe place. The apparatus 100 may trigger to turn off the equipment or host device to prevent thermal runaway.

FIG. 5B illustrates a use case scenario in which a fault with low severity is identified in the re-chargeable battery 101 of the equipment and/or the components connected to the re-chargeable battery(s) 101, according to an embodiment.

In an example, the apparatus 100 may notify the user to visit the service center if a fault with low severity is identified in the re-chargeable battery 101 of the equipment and/or the components connected to the re-chargeable battery(s) 101. In another example, the apparatus 100 may store log data related to the fault.

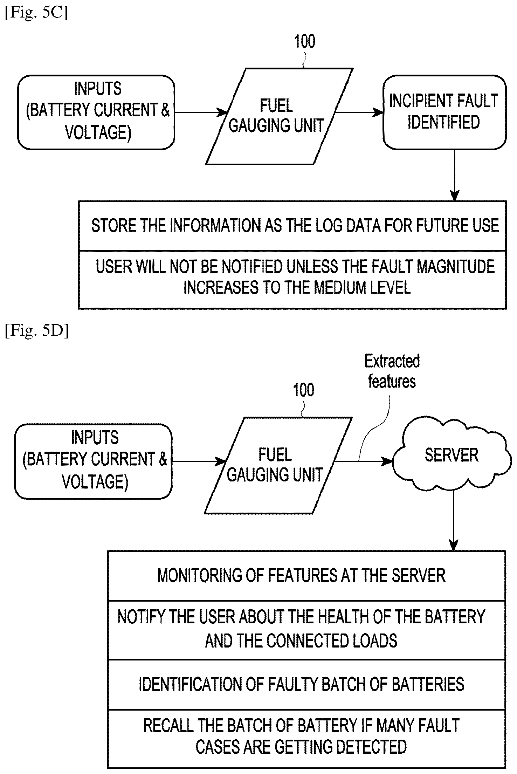

FIG. 5C illustrates a use case scenario in which an incipient fault is identified in the re-chargeable battery 101 of the equipment and/or the components connected to the re-chargeable battery(s) 101, according to an embodiment.

In an example, if the detected fault is minor and likely to develop, then the fault is referred as an incipient fault. The log data may be stored by the apparatus 100 for further use by the apparatus 100 or service center. The user may not be notified regarding the incipient fault, if the threshold value of the fault is medium level fault.

FIG. 5D illustrates a use case scenario in which a fault is detected using a server, in the re-chargeable battery 101 of the equipment and/or the components connected to the re-chargeable battery(s) 101, according to an embodiment.

The features extracted by the apparatus 100 may be transmitted to the server via a communication network. The server may monitor the feature and notify the user regarding the health status of the re-chargeable battery 101 of the equipment and/or the components connected to the re-chargeable battery(s) 101. Further, the server may identify batch of faulty re-chargeable battery 101 based on identifying the health status of the at least one of the re-chargeable battery 101 of the equipment. The user may be notified to recall or exchange the faulty battery 101 of the equipment under the identified faulty batch of re-chargeable batteries.

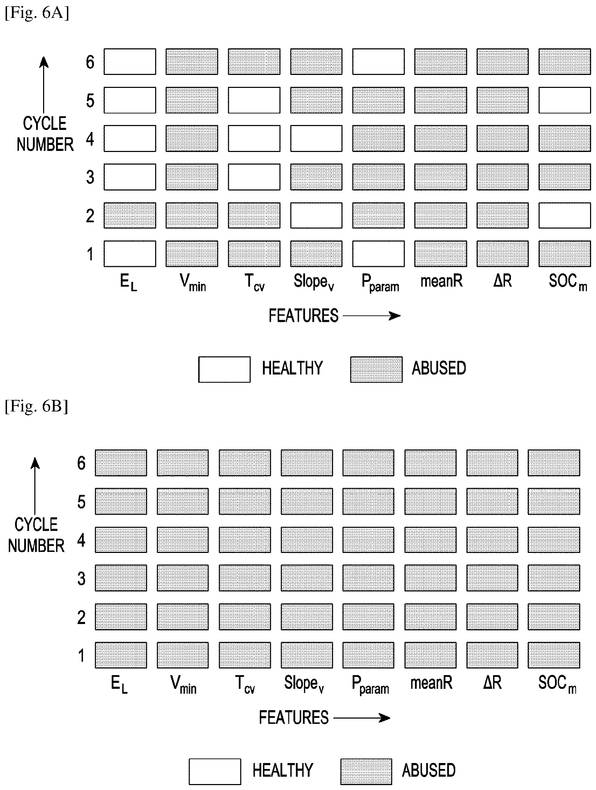

FIG. 6A illustrates a use case scenario to detect moderate abuse of the re-chargeable battery 101 of the equipment and/or the components connected to the re-chargeable battery(s) 101, according to an embodiment.

The Feature Import Index (FII) may be identified to determine the abuse of the re-chargeable battery 101 of the equipment and/or the components connected to the re-chargeable battery(s) 101. In each cycle of the received parametric data, the calculated feature value may vary based on the severity of the fault.

FIG. 6B illustrates a use case scenario in which a severe short circuit is detected in the re-chargeable battery 101 of the equipment and/or the components connected to the re-chargeable battery(s) 101, according to an embodiment.

The Feature Import Index (FII) may be identified to determine the short circuit in the re-chargeable battery 101 of the equipment and/or the components connected to the re-chargeable battery(s) 101. The internal short may be due to electrochemical anomaly in the re-chargeable battery 101 of the equipment. The anomalous battery behavior may be identified using the fuel gauge (I, V) data or parametric data.

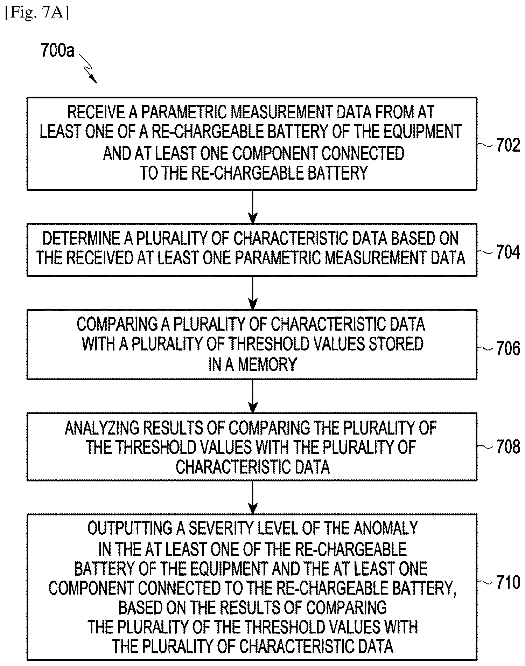

FIG. 7A illustrates a flowchart of a method 700a for identifying anomaly in at least one of the re-chargeable battery 101 of the equipment and at least one component connected to the re-chargeable battery 101, according to an embodiment.

At step 702, the method 700a includes receiving by the processing unit 102, parametric measurement data from at least one of the re-chargeable battery 101 of the equipment and at least one component connected to the re-chargeable battery 101, in which the parametric measurement data comprises at least one of current measurement data, voltage measurement data, and temperature measurement data. At step 704, the method 700a includes determining by the processing unit 102, a plurality of characteristic data based on the received at least one parametric measurement data. At step 706, the method 700a includes comparing by the processing unit 102, the plurality of characteristic data with a plurality of threshold values stored in a memory unit 104. At step 708, the method 700a includes analyzing by the processing unit 102, results of comparing the plurality of the threshold values with the plurality of characteristic data. At step 710, the method 700a includes outputting by the processing unit 102, a severity level of the anomaly in the at least one of the re-chargeable battery 101 of the equipment and at least one component connected to the re-chargeable battery 101, based on the results of comparing the plurality of the threshold values with the plurality of the characteristic data. The severity level of anomaly comprise, for example, at least one of, a negligent level, a warning level, and a critical level.

The various actions in method 700a may be performed in the order presented, in a different order or simultaneously. Further, in some embodiments, some actions shown in FIG. 7A may be omitted.

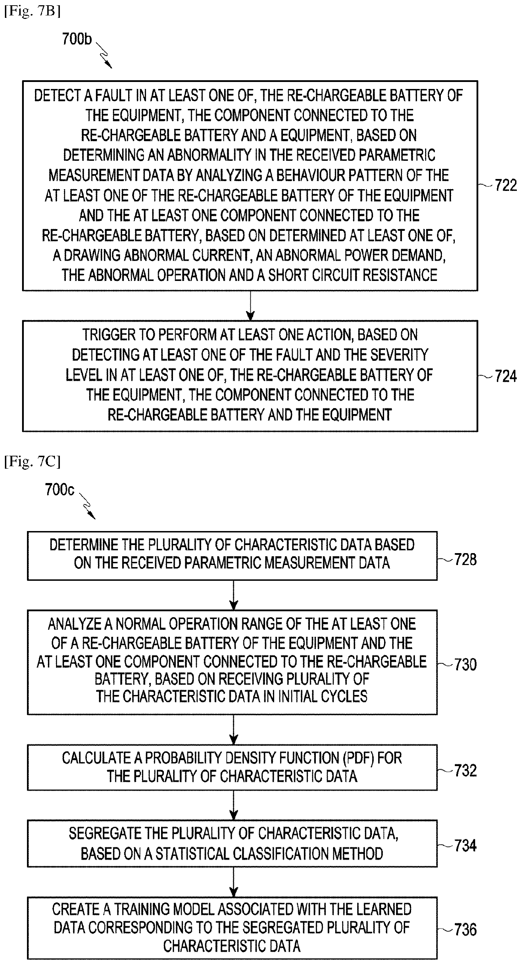

FIG. 7B illustrates a flowchart of a method 700b for triggering to turn off the equipment or the host device, according to an embodiment.

At step 722, the method 700b includes, detecting by the processing unit 102, a fault in at least one of, the re-chargeable battery 101 of the equipment, the components connected to the re-chargeable battery 101 and the equipment, based on determining an abnormality in the received parametric measurement data. In an embodiment, determining the abnormality of the parametric measurement data comprises analyzing a behavior pattern of the at least one of the re-chargeable battery 101 of the equipment and the at least one component connected to the re-chargeable battery 101, based on the determined at least one of, a drawing abnormal current, an abnormal power demand, an abnormal operation and a short circuit resistance. At step 724, the method 700b includes, triggering by the processing unit 102, to perform at least one action, based on detecting at least one of the fault and the severity level in at least one of, the re-chargeable battery 101 of the equipment, the components connected to the re-chargeable battery 101 and the equipment, and the at least one action comprises at least one of, turning off the equipment, entering hibernate mode, entering power saving mode, and notify emergency contact.

The various actions in method 700b may be performed in the order presented, in a different order or simultaneously. Further, in some embodiments, some actions listed in FIG. 7B may be omitted.

FIG. 7C illustrates a flowchart of a method 700c for creating a training model associated with the learned data corresponding to the plurality of the characteristic data, according to an embodiment.

At step 728, the method 700c includes, determining by the processing unit 102, the plurality of characteristic data based on the received parametric measurement data. At step 730, the method 700c includes analyzing by the processing unit 102, a normal operation range of the at least one of the re-chargeable battery 101 of the equipment and the at least one component connected to the re-chargeable battery 101, based on receiving plurality of the characteristic data in initial cycles. At step 732, the method 700c includes, calculating by the processing unit 102, a Probability Density Function (PDF) for the plurality of characteristic data. At step 734, the method 700c includes, segregating by the processing unit 102, the plurality of characteristic data, based on a statistical classification method. At step 736, the method 700c includes, creating by the processing unit 102, a training model associated with the learned data corresponding to the segregated plurality of characteristic data.

The various actions in method 700c may be performed in the order presented, in a different order or simultaneously. Further, in some embodiments, some actions listed in FIG. 7C may be omitted.

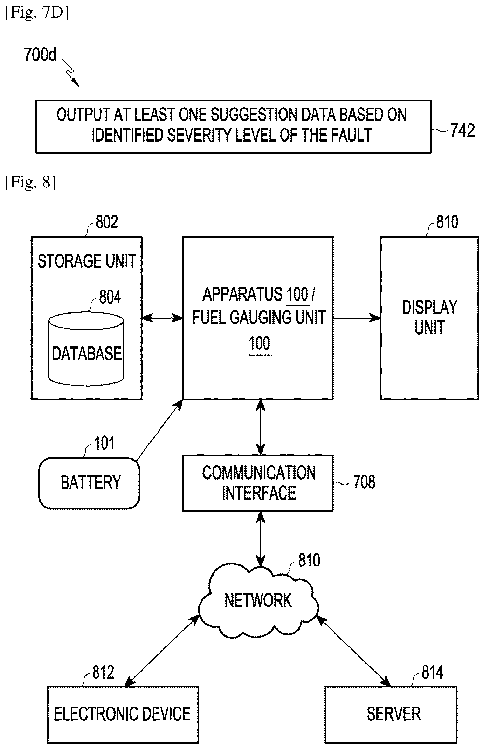

FIG. 7D illustrates a flowchart of a method 700d for outputting at least one suggestion data based on identified severity level of the fault, according to an embodiment.

At step 742, the method 700d includes, outputting by the processing unit 102, at least one suggestion data based on the identified severity level of the fault, and outputting the at least one suggestion data may include at least one of, a notification to visit service center, a notification to connect the equipment to specific adapter, and a notification to turn off the equipment.

The various actions in method 700d may be performed in the order presented, in a different order or simultaneously. Further, in some embodiments, some actions listed in FIG. 7D may be omitted.

FIG. 8 is a system 800 for identifying an anomaly in at least one of the re-chargeable battery 101 of the equipment and at least one component connected to the re-chargeable battery 101, according to an embodiment.

In an alternate embodiment, the system 800 may include apparatus 100/fuel gauging unit 100, the re-chargeable battery 101 of the equipment, a storage unit 802, a display unit 806, a communication interface 708, a communication network 810, an electronic device 812, and a server 814. The apparatus 100/ fuel gauging unit 100 may reside in at least one of host device, equipment, vehicle and other electronic device. The display unit 806 can reside in at least one of, but not limited to, vehicle, host device, equipment. In an embodiment, the apparatus 100 may transmit the data or notification to display unit 806 in communicatively coupled display unit 806 or to display in communicatively coupled electronic device 812. In an embodiment, the apparatus 100 may transmit the data to the server 814 for monitoring the fault of the at least one of the re-chargeable battery 101 of the equipment and at least one component connected to the re-chargeable battery 101 of the equipment.

The embodiments disclosed herein can be implemented through at least one software program running on at least one hardware device and performing network management functions to control the elements. The elements shown in FIG. 1 and FIG. 8 can be at least one of a hardware device, or a combination of hardware device and software module.

**Claims**

1. A method for identifying an anomaly in at least one of a re-chargeable battery (101) of an equipment and at least one component connected to the re-chargeable battery, the method comprising:

   receiving, by a processor (102), training parametric measurement data from at least one of the re-chargeable battery of the equipment and the at least one component connected to the re-chargeable battery, wherein the parametric measurement data comprises at least one of current measurement data, voltage measurement data, and temperature measurement data;
   creating a training model based on the received training parametric measurement data;
   determining, by the processor, a first plurality of characteristic data from the training model;
   receiving, by a processor, test parametric measurement data from the at least one of the re-chargeable battery of the equipment and the at least one component connected to the re-chargeable battery;
   determining, by the processor, a second plurality of characteristic data based on the test parametric measurement data;
   comparing, by the processor, the second plurality of characteristic data with the first plurality of characteristic data determined from the training model;
   analyzing, by the processor, a value of a probability of an anomaly in the at least one of the re-chargeable battery of the equipment and at least one component connected to the re-chargeable battery based on the comparison; and
   if the probability is above a threshold, outputting, by the processor, a severity level of the anomaly in the at least one of the re-chargeable battery of the equipment and the at least one component connected to the re-chargeable battery,
   wherein creating the training model of learned data further comprises:

      analyzing (730), by the processor, a normal operation range of the at least one of a re-chargeable battery of the equipment and the at least one component connected to the re-chargeable battery, based on the first plurality of the characteristic data ;
      calculating (732), by the processor, a Probability Density Function, PDF, for the first plurality of characteristic data;
      segregating (734), by the processor, the first plurality of characteristic data, based on a statistical classification method; and
      creating (736), by the processor, a training model associated with the learned data corresponding to the segregated first plurality of characteristic data.

2. The method as claimed in claim 1, further comprising:

   detecting, by the processor, a fault in the at least one of the re-chargeable battery of the equipment and the at least one component connected to the re-chargeable battery, based on determining an abnormality in the received parametric measurement data by analyzing a behavior pattern of the at least one of the re-chargeable battery of the equipment and the at least one component connected to the re-chargeable battery, based on at least one of a drawing abnormal current, an abnormal power demand, the abnormal operation, and a short circuit resistance; and
   triggering, by the processor, to perform at least one action, based on detecting at least one of the fault and the severity level in at least one of the re-chargeable battery of the equipment and the at least one component connected to the re-chargeable battery,
   wherein the at least one action comprises at least one of turning off the equipment, entering a hibernate mode, entering a power saving mode, and outputting an emergency message.

3. The method as claimed in claim 1, further comprising:

outputting, by the processor, at least one suggestion based on an identified severity level of a fault, wherein the at least one suggestion data comprises at least one of a notification to visit service center, a notification to connect the equipment to specific adapter, and a notification to turn off the equipment.

4. The method as claimed in claim 3, wherein the outputting the at least one suggestion based on identified severity level of the fault comprises storing a log data associated with the severity level of fault.

5. The method as claimed in claim 4, wherein storing the log data associated with the severity level of the fault further comprises transmitting the log data to a server for identification of faulty batch of re-chargeable batteries.

6. The method as claimed in claim 1, wherein the plurality of characteristic data comprises at least one of a loss of energy, $E_L$, between charging and discharging of re-chargeable battery, a terminal voltage, $V_t$, at fixed low State Of Charge, SOC, 5% level, $V_{min}$, of re-chargeable battery , a Constant Voltage, CV, phase time, $T_{cv}$, a discharge voltage slope, $Slope_v$, a maximum value of SOC at the end of charging, $SOC_m$, of the re-chargeable battery, a first order slope parameter from the Vt vs. SOC Polynomial curve fitting, polyfit, parameters, $P_{param}$, a mean of estimated internal resistance during discharge, meanR, of the re-chargeable battery, and a difference of end of charge resistance and start of discharge, $\Delta R$, of the re-chargeable battery.

7. The method as claimed in claim 6, further comprising identifying at least one of an increase in a value of the characteristic data, a decrease in a value of the characteristic data, and a similarity in a value of the characteristic data.

8. The method as claimed in claim 7, wherein outputting the anomaly associated with the at least one of the re-chargeable battery and the at least one component connected to the re-chargeable battery comprises outputting the anomaly if a value of at least one of, the EL, the TCV, the SlopeV, the Pparam, and the SOCm is increased above the threshold value.

9. The method as claimed in claim 7, wherein outputting the anomaly associated with the at least one of the re-chargeable battery of the equipment and the at least one component connected to the re-chargeable battery comprises outputting the anomaly if a value of at least one of, the Vmin, the meanR, and the $\Delta R$ is decreased below the threshold value.

10. The method as claimed in claim 1, further comprising,

determining a health status of the at least one of the re-chargeable battery of the equipment and the at least one component connected to the re-chargeable battery,
if the health status is determined to be positive, repeating the creating of the training model;
and if the health status is determined to be negative, determining, using likelihood estimation method, the value of the probability of the anomaly corresponding to the at least one of the re-chargeable battery [figure 4].

11. An apparatus (100) for identifying an anomaly in at least one of a re-chargeable battery (101) of an equipment and at least one component connected to the re-chargeable battery , the apparatus comprising:

a processor (102); and
a memory (104) coupled to the processor, wherein the memory stores computer-readable instructions, which when executed by the processor cause the apparatus to:

receive training parametric measurement data from at least one of the re-chargeable battery of the equipment and at least one component connected to the re-chargeable battery, wherein the parametric measurement data comprises at least one of current measurement data, voltage measurement data, and temperature measurement data;
create a training model based on the received training parametric measurement data;
determine a first plurality of characteristic data from the training model;
receive test parametric measurement data from the at least one of the re-chargeable battery of the equipment and the at least one component connected to the re-chargeable battery;
determine a second plurality of characteristic data based on the test parametric measurement data;
compare the second plurality of characteristic data with the first plurality of characteristic data determined from the training model;
analyze a value of a probability of an anomaly in the at least one of the re-chargeable battery of the equipment and at least one component connected to the re-chargeable battery based on the comparison; and

if the probability is above a threshold, output a severity level of the anomaly in the at least one of the re-chargeable battery of the equipment and at least one component connected to the re-chargeable battery, wherein the processor executing the computer-readable instructions further causes the apparatus to:

analyze (730) a normal operation range of the at least one of the re-chargeable battery of the equipment and the at least one component connected to the re-chargeable battery;
calculate (732) a Probability Density Function, PDF, for the plurality of characteristic data;
segregate (734) the plurality of characteristic data, based on a statistical classification method; and
create (736) a training model associated with the learned data corresponding to the segregated plurality of characteristic data.

12. The apparatus as claimed in claim 11, wherein the processor executing the computer-readable instructions further causes the apparatus to:

detect a fault in the at least one of the re-chargeable battery of the equipment and the at least one component connected to the re-chargeable battery, based on determining an abnormality in the received parametric measurement data by analyzing a behavior pattern of the at least one of the re-chargeable battery of the equipment and the at least one component connected to the re-chargeable battery, based on at least one of a drawing abnormal current, an abnormal power demand, an abnormal operation and a short circuit resistance; and
trigger to perform at least one action, based on detecting at least one of the fault and the severity level in at least one of the re-chargeable battery of the equipment and the at least one component connected to the re-chargeable battery,
wherein the at least one action comprises at least one of turning off the equipment, entering a hibernate mode, entering a power saving mode, and outputting an emergency message.

13. The apparatus as claimed in claim 11, wherein the plurality of characteristic data comprises at least one of a loss of energy, $E_L$, between charging and discharging of re-chargeable battery, a terminal voltage, $V_t$, at fixed low State Of Charge, SOC, 5% level, $V_{min}$, of re-chargeable battery , a Constant Voltage, CV, phase time, Tcv, a discharge voltage slope, Slopev, a maximum value of SOC at the end of charging, SOCm, of the re-chargeable battery, a first order slope parameter from the Vt vs. SOC Polynomial curve fitting, polyfit, parameters, $P_{param}$, a mean of estimated internal resistance during discharge, meanR, of the re-chargeable battery, and a difference of end of charge resistance and start of discharge, $\Delta R$, of the re-chargeable battery.

## Patentansprüche

1. Verfahren zum Identifizieren einer Anomalie in einer wiederaufladbaren Batterie (101) eines Geräts und/oder mindestens einer Komponente, die mit der wiederaufladbaren Batterie verbunden ist, wobei das Verfahren Folgendes umfasst:

Empfangen von parametrischen Trainingsmessdaten von der wiederaufladbaren Batterie des Geräts und/oder der mindestens einen Komponente, die mit der wiederaufladbaren Batterie verbunden ist, durch einen Prozessor (102), wobei die parametrischen Messdaten Strommessdaten, Spannungsmessdaten und/oder Temperaturmessdaten umfassen;
Erstellen eines Trainingsmodells basierend auf den empfangenen parametrischen Trainingsmessdaten;
Bestimmen einer ersten Vielzahl von charakteristischen Daten aus dem Trainingsmodell durch den Prozessor;
Empfangen von parametrischen Testmessdaten von der wiederaufladbaren Batterie des Geräts und/oder der mindestens einen Komponente, die mit der wiederaufladbaren Batterie verbunden ist, durch einen Prozessor;
Bestimmen einer zweiten Vielzahl von charakteristischen Daten durch den Prozessor basierend auf den parametrischen Testmessdaten;
Vergleichen der zweiten Vielzahl von charakteristischen Daten mit der ersten Vielzahl von charakteristischen Daten, die aus dem Trainingsmodell bestimmt werden, durch den Prozessor;
Analysieren eines Werts einer Wahrscheinlichkeit einer Anomalie in der wiederaufladbaren Batterie des Geräts und/oder mindestens einer Komponente, die mit der wiederaufladbaren Batterie verbunden ist, durch den Prozessor basierend auf dem Vergleich; und
wenn die Wahrscheinlichkeit über einer Schwelle liegt, Ausgeben eines Schweregrads der Anomalie in der wiederaufladbaren Batterie des Geräts und/oder der mindestens einen Komponente, die mit der wiederauflad-

12

baren Batterie verbunden ist, durch den Prozessor,
wobei das Erstellen des Trainingsmodells aus gelernten Daten ferner Folgendes umfasst:

Analysieren (730) eines normalen Betriebsbereichs der wiederaufladbaren Batterie des Geräts und/oder der mindestens einen Komponente, die mit der wiederaufladbaren Batterie verbunden ist, durch den Prozessor basierend auf der ersten Vielzahl der charakteristischen Daten;
Berechnen (732) einer Wahrscheinlichkeitsdichtefunktion, PDF, für die erste Vielzahl von charakteristischen Daten durch den Prozessor;
Trennen (734) der ersten Vielzahl von charakteristischen Daten durch den Prozessor basierend auf einem statistischen Klassifizierungsverfahren; und
Erstellen (736) eines Trainingsmodells durch den Prozessor, das mit den gelernten Daten assoziiert ist, die der getrennten ersten Vielzahl von charakteristischen Daten entsprechen.

2. Verfahren nach Anspruch 1, das ferner Folgendes umfasst:

Erkennen eines Fehlers in der wiederaufladbaren Batterie des Geräts und/oder der mindestens einen Komponente, die mit der wiederaufladbaren Batterie verbunden ist, durch den Prozessor basierend auf dem Bestimmen einer Anomalie in den empfangenen parametrischen Messdaten durch Analysieren eines Verhaltensmusters der wiederaufladbaren Batterie des Geräts und/oder der mindestens einen Komponente, die mit der wiederaufladbaren Batterie verbunden ist, basierend auf einer abnormalen Stromaufnahme, einem abnormalen Strombedarf, dem abnormalen Betrieb und/oder einem Kurzschlusswiderstand; und
Auslösen zum Ausführen mindestens einer Aktion durch den Prozessor basierend auf dem Erkennen des Fehlers und/oder des Schweregrads in der wiederaufladbaren Batterie des Geräts und/oder der mindestens einen Komponente, die mit der wiederaufladbaren Batterie verbunden ist,
wobei die mindestens eine Aktion das Abschalten des Geräts, das Eintreten in einen Ruhemodus, das Eintreten in einen Stromsparmodus und/oder das Ausgeben einer Notfallnachricht umfasst.

3. Verfahren nach Anspruch 1, das ferner Folgendes umfasst:

Ausgeben mindestens einer Anregung durch den Prozessor basierend auf einem identifizierten Schweregrad eines Fehlers,
wobei die mindestens eine Anregungsdateneinheit eine Benachrichtigung zum Besuch des Dienstzentrums, eine Benachrichtigung zum Verbinden des Geräts mit dem spezifischen Adapter und/oder eine Benachrichtigung zum Abschalten des Geräts umfasst.

4. Verfahren nach Anspruch 3, wobei das Ausgeben der mindestens einen Anregung basierend auf dem identifizierten Schweregrad des Fehlers das Speichern von Protokolldaten umfasst, die mit dem Schweregrad des Fehlers assoziiert sind.

5. Verfahren nach Anspruch 4, wobei das Speichern der Protokolldaten, die mit dem Schweregrad des Fehlers assoziiert sind, ferner das Übertragen der Protokolldaten an einen Server zur Identifizierung einer fehlerhaften Charge wiederaufladbarer Batterien umfasst.

6. Verfahren nach Anspruch 1, wobei die Vielzahl von charakteristischen Daten einen Energieverlust, $E_L$, zwischen dem Laden und Entladen der wiederaufladbaren Batterie, eine Klemmenspannung, Vt, bei einer festen niedrigen Ladezustands(SOC)-Höhe von 5 %, $V_{min}$, der wiederaufladbaren Batterie, eine Konstantspannungs(CV)-Phasenzeit, $T_{cv}$, eine Entladungsspannungssteigung, $Slope_v$, einen Maximalwert des SOC am Ende des Ladevorgangs, $SOC_m$, der wiederaufladbaren Batterie, einen Steigungsparameter erster Ordnung aus der Vt im Vergleich zu den SOC-Polynomkurvenanpassungs(polyfit)-Parametern, $P_{param}$, einen Mittelwert des geschätzten Innenwiderstands während der Entladung, meanR, der wiederaufladbaren Batterie und/oder eine Differenz zwischen dem Widerstand am Ende des Ladevorgangs und dem Beginn der Entladung, $\Delta R$, der wiederaufladbaren Batterie umfassen.

7. Verfahren nach Anspruch 6, das ferner das Identifizieren einer Zunahme eines Werts der charakteristischen Daten, einer Abnahme eines Werts der charakteristischen Daten und/oder einer Ähnlichkeit eines Werts der charakteristischen Daten umfasst.

8. Verfahren nach Anspruch 7, wobei das Ausgeben der Anomalie, die mit der wiederaufladbaren Batterie und/oder der mindestens einen Komponente assoziiert ist, die mit der wiederaufladbaren Batterie verbunden ist, das Ausgeben der Anomalie umfasst, wenn ein Wert des EL, der TCV, der SlopeV, der Pparam und/oder des SOCm über den Schwellenwert erhöht ist.

9. Verfahren nach Anspruch 7, wobei das Ausgeben der Anomalie, die mit der wiederaufladbaren Batterie des Geräts und/oder der mindestens einen Komponente assoziiert ist, die mit der wiederaufladbaren Batterie verbunden ist, das Ausgeben der Anomalie umfasst, wenn ein Wert der Vmin, des meanR und/oder der ΔR unter den Schwellenwert gesunken ist.

10. Verfahren nach Anspruch 1, das ferner Folgendes umfasst,

Bestimmen eines Gesundheitszustands der wiederaufladbaren Batterie des Geräts und/oder der mindestens einen Komponente, die mit der wiederaufladbaren Batterie verbunden ist, wenn der Gesundheitszustand als positiv bestimmt wird, Wiederholen des Erstellens des Trainingsmodells; und wenn der Gesundheitszustand als negativ bestimmt wird, Bestimmen des Werts der Wahrscheinlichkeit der Anomalie, die der mindestens einen der wiederaufladbaren Batterien [Abbildung 4] entspricht, unter Verwenden eines Wahrscheinlichkeitsschätzverfahrens.

11. Vorrichtung (100) zum Identifizieren einer Anomalie in einer wiederaufladbaren Batterie (101) eines Geräts und/oder mindestens einer Komponente, die mit der wiederaufladbaren Batterie verbunden ist, wobei die Vorrichtung Folgendes umfasst:

einen Prozessor (102); und einen Speicher (104), der mit dem Prozessor gekoppelt ist, wobei der Speicher computerlesbare Anweisungen speichert, die, wenn sie von dem Prozessor ausgeführt werden, die Vorrichtung zu Folgendem veranlassen:

Empfangen von parametrischen Trainingsmessdaten von der wiederaufladbaren Batterie des Geräts und/oder mindestens einer Komponente, die mit der wiederaufladbaren Batterie verbunden ist, wobei die parametrischen Messdaten Strommessdaten, Spannungsmessdaten und/oder Temperaturmessdaten umfassen; Erstellen eines Trainingsmodells basierend auf den empfangenen parametrischen Trainingsmessdaten; Bestimmen einer ersten Vielzahl von charakteristischen Daten aus dem Trainingsmodell; Empfangen von parametrischen Testmessdaten von der wiederaufladbaren Batterie des Geräts und/oder der mindestens einen Komponente, die mit der wiederaufladbaren Batterie verbunden ist; Bestimmen einer zweiten Vielzahl von charakteristischen Daten basierend auf den parametrischen Testmessdaten; Vergleichen der zweiten Vielzahl von charakteristischen Daten mit der ersten Vielzahl von charakteristischen Daten, die aus dem Tainingsmodell bestimmt werden; Analysieren eines Werts einer Wahrscheinlichkeit einer Anomalie in der wiederaufladbaren Batterie des Geräts und/oder mindestens einer Komponente, die mit der wiederaufladbaren Batterie verbunden ist, basierend auf dem Vergleich; und wenn die Wahrscheinlichkeit über einer Schwelle liegt, Ausgeben eines Schweregrads der Anomalie in der wiederaufladbaren Batterie des Geräts und/oder mindestens einer Komponente, die mit der wiederaufladbaren Batterie verbunden ist, wobei der Prozessor, der die computerlesbaren Anweisungen ausführt, die Vorrichtung ferner zu Folgendem veranlasst:

Analysieren (730) eines normalen Betriebsbereichs der wiederaufladbaren Batterie des Geräts und/oder der mindestens einen Komponente, die mit der wiederaufladbaren Batterie verbunden ist; Berechnen (732) einer Wahrscheinlichkeitsdichtefunktion, PDF, für die Vielzahl von charakteristischen Daten; Trennen (734) der Vielzahl von charakteristischen Daten basierend auf einem statistischen Klassifizierungsverfahren; und Erstellen (736) eines Trainingsmodells, das mit den gelernten Daten assoziiert ist, die der getrennten Vielzahl von charakteristischen Daten entsprechen.

12. Vorrichtung nach Anspruch 11, wobei der Prozessor, der die computerlesbaren Anweisungen ausführt, die Vorrichtung ferner zu Folgendem veranlasst:

Erkennen eines Fehlers in der wiederaufladbaren Batterie des Geräts und/oder der mindestens einen Komponente, die mit der wiederaufladbaren Batterie verbunden ist, basierend auf dem Bestimmen einer Anomalie in den empfangenen parametrischen Messdaten durch Analysieren eines Verhaltensmusters der wiederaufladbaren Batterie des Geräts und/oder der mindestens einen Komponente, die mit der wiederaufladbaren Batterie verbunden ist, basierend auf einer abnormalen Stromaufnahme, einem abnormalen Strombedarf, einem abnormalen Betrieb und/oder einem Kurzschlusswiderstand; und

Auslösen zum Ausführen mindestens einer Aktion basierend auf dem Erkennen des Fehlers und/oder des Schweregrads in der wiederaufladbaren Batterie des Geräts und/oder der mindestens einen Komponente, die mit der wiederaufladbaren Batterie verbunden ist,

wobei die mindestens eine Aktion das Abschalten des Geräts, das Eintreten in einen Ruhemodus, das Eintreten in einen Stromsparmodus und/oder das Ausgeben einer Notfallnachricht umfasst.

13. Vorrichtung nach Anspruch 11, wobei die Vielzahl von charakteristischen Daten einen Energieverlust, $E_L$, zwischen dem Laden und Entladen der wiederaufladbaren Batterie, eine Klemmenspannung, Vt, bei einer festen niedrigen Ladezustands(SOC)-Höhe von 5 %, $V_{min}$, der wiederaufladbaren Batterie, eine Konstantspannungs(CV)-Phasenzeit, Tcv, eine Entladungsspannungssteigung, Slopev, einen Maximalwert des SOC am Ende des Ladevorgangs, SOCm, der wiederaufladbaren Batterie, einen Steigungsparameter erster Ordnung aus der Vt im Vergleich zu den SOC-Polynomkurvenanpassungs(polyfit)-Parametern, $P_{param}$, einen Mittelwert des geschätzten Innenwiderstands während der Entladung, meanR, der wiederaufladbaren Batterie und/oder eine Differenz zwischen dem Widerstand am Ende des Ladevorgangs und dem Beginn der Entladung, $\Delta R$, der wiederaufladbaren Batterie umfassen.

## Revendications

1. Procédé d'identification d'une anomalie dans au moins un élément parmi une batterie rechargeable (101) d'un équipement et au moins un composant connecté à la batterie rechargeable, le procédé comprenant :

recevoir, par un processeur (102), des données de mesures paramétriques d'apprentissage provenant d'au moins un élément parmi la batterie rechargeable de l'équipement et l'au moins un composant connecté à la batterie rechargeable, où les données de mesures paramétriques comprennent au moins un élément parmi des données de mesures de courant, des données de mesures de tension et des données de mesures de température ;

créer un modèle d'apprentissage sur la base des données de mesures paramétriques d'apprentissage reçues ;

déterminer, par le processeur, une première pluralité de données caractéristiques à partir du modèle d'apprentissage ;

recevoir, par un processeur, des données de mesures paramétriques de test provenant de l'au moins un élément parmi la batterie rechargeable de l'équipement et l'au moins un composant connecté à la batterie rechargeable ;

déterminer, par le processeur, une deuxième pluralité de données caractéristiques sur la base des données de mesures paramétriques de test ;

comparer, par le processeur, la deuxième pluralité de données caractéristiques à la première pluralité de données caractéristiques déterminées à partir du modèle d'apprentissage ;

analyser, par le processeur, une valeur d'une probabilité d'une anomalie dans l'au moins un élément parmi la batterie rechargeable de l'équipement et au moins un composant connecté à la batterie rechargeable sur la base de la comparaison ; et

si la probabilité est supérieure à un seuil, délivrer, par le processeur, un niveau de gravité de l'anomalie dans l'au moins un élément parmi la batterie rechargeable de l'équipement et l'au moins un composant connecté à la batterie rechargeable,

où la création du modèle d'apprentissage de données apprises comprend en outre :

analyser (730), par le processeur, une plage de fonctionnement normal de l'au moins un élément parmi une batterie rechargeable de l'équipement et l'au moins un composant connecté à la batterie rechargeable, sur la base de la première pluralité de données caractéristiques ;

calculer (732), par le processeur, une fonction de densité de probabilité, PDF, pour la première pluralité de données caractéristiques ;

séparer (734), par le processeur, la première pluralité de données caractéristiques, sur la base d'un procédé de classification statistique ; et

créer (736), par le processeur, un modèle d'apprentissage associé aux données apprises correspondant à la première pluralité séparée de données caractéristiques.

**2.** Procédé selon la revendication 1, comprenant en outre :

détecter, par le processeur, un défaut dans l'au moins un élément parmi la batterie rechargeable de l'équipement et l'au moins un composant connecté à la batterie rechargeable, sur la base de la détermination d'une anomalie dans les données de mesures paramétriques reçues en analysant un modèle de comportement de l'au moins un élément parmi la batterie rechargeable de l'équipement et l'au moins un composant connecté à la batterie rechargeable, sur la base d'au moins un élément parmi un prélèvement anormal de courant, une demande anormale de puissance, un fonctionnement anormal, et une résistance de court-circuit ; et

déclencher, par le processeur, l'exécution d'au moins une action, sur la base de la détection d'au moins un élément parmi le défaut et le niveau de gravité dans au moins un élément parmi la batterie rechargeable de l'équipement et l'au moins un composant connecté à la batterie rechargeable,

où ladite au moins une action comprend au moins une action parmi éteindre l'équipement, entrer dans un mode d'hibernation, entrer dans un mode d'économie d'énergie et délivrer un message d'urgence.

**3.** Procédé selon la revendication 1, comprenant en outre :

délivrer, par le processeur, au moins une suggestion sur la base d'un niveau de gravité identifiée d'un défaut, où ladite au moins une donnée de suggestion comprend au moins une notification parmi une notification pour visiter un centre de service, une notification pour connecter l'équipement à un adaptateur spécifique, et une notification pour éteindre l'équipement.

**4.** Procédé selon la revendication 3, où la sortie de l'au moins une suggestion sur la base du niveau de gravité identifiée du défaut comprend le stockage de données de journal associées au niveau de gravité du défaut.

**5.** Procédé selon la revendication 4, où le stockage des données de journal associées au niveau de gravité du défaut comprend en outre la transmission des données de journal à un serveur pour l'identification du lot défectueux de batteries rechargeables.

**6.** Procédé selon la revendication 1, où la pluralité de données caractéristiques comprend au moins un élément parmi une perte d'énergie, $E_L$, entre la charge et la décharge de la batterie rechargeable, une tension aux bornes, Vt, à un état de charge, SOC, fixé au faible niveau de 5%, $V_{min}$, de batterie rechargeable, un temps de phase, Tcv, de Tension Constante, CV, une pente de tension de décharge, Slopev, une valeur maximale de SOC en fin de charge, $SOC_m$, de la batterie rechargeable, un paramètre de pente de premier ordre à partir des paramètres, $P_{param}$, de l'ajustement de la courbe polynomiale, polyfit, Vt vs SOC, une moyenne de la résistance interne estimée pendant la décharge, meanR, de la batterie rechargeable, et une différence de résistance de fin de charge et début de décharge, $\Delta R$, de la batterie rechargeable.

**7.** Procédé selon la revendication 6, comprenant en outre l'identification d'au moins un élément parmi une augmentation d'une valeur des données caractéristiques, une diminution d'une valeur des données caractéristiques et une similarité d'une valeur des données caractéristiques.

**8.** Procédé selon la revendication 7, où la sortie de l'anomalie associée à l'au moins un élément parmi la batterie rechargeable et l'au moins un composant connecté à la batterie rechargeable comprend la sortie de l'anomalie si une valeur d'au moins un élément parmi $E_L$, Tcv, Slopev, $P_{param}$ et $SOC_m$ est augmentée au-dessus de la valeur de seuil.

**9.** Procédé selon la revendication 7, où la sortie de l'anomalie associée à l'au moins un élément parmi la batterie rechargeable de l'équipement et l'au moins un composant connecté à la batterie rechargeable comprend la sortie de l'anomalie si une valeur d'au moins l'un parmi $V_{min}$, meanR et $\Delta R$ est diminuée en dessous de la valeur de seuil.

**10.** Procédé selon la revendication 1, comprenant en outre,

déterminer un état de santé de l'au moins un élément parmi la batterie rechargeable de l'équipement et l'au moins un composant connecté à la batterie rechargeable,

si l'état de santé est déterminé comme étant positif, répéter la création du modèle d'entraînement ; et

si l'état de santé est déterminé comme étant négatif, déterminer, à l'aide d'un procédé d'estimation de vraisemblance, la valeur de la probabilité de l'anomalie correspondant à au moins une batterie rechargeable [figure 4].

**11.** Appareil (100) pour identifier une anomalie dans au moins un élément parmi une batterie rechargeable (101) d'un équipement et au moins un composant connecté à la batterie rechargeable, l'appareil comprenant :

un processeur (102) ; et
une mémoire (104) couplée au processeur, où la mémoire stocke des instructions lisibles par ordinateur qui, lorsqu'elles sont exécutées par le processeur, amènent l'appareil à :

recevoir des données de mesures paramétriques d'apprentissage d'au moins un élément parmi la batterie rechargeable de l'équipement et au moins un composant connecté à la batterie rechargeable, les données de mesures paramétriques comprenant au moins un élément parmi des données de mesures de courant, des données de mesures de tension, et des données de mesures de température ;
créer un modèle d'entraînement sur la base des données de mesures paramétriques d'entraînement reçues, déterminer une première pluralité de données caractéristiques à partir du modèle d'apprentissage ;
recevoir des données de mesures paramétriques de test à partir de l'au moins un élément parmi une batterie rechargeable de l'équipement et l'au moins un composant connecté à la batterie rechargeable ;
déterminer une deuxième pluralité de données caractéristiques sur la base des données de mesures paramétriques de test ;
comparer la deuxième pluralité de données caractéristiques avec la première pluralité de données caractéristiques déterminées à partir du modèle d'apprentissage ;
analyser une valeur d'une probabilité d'anomalie dans l'au moins un élément parmi la batterie rechargeable de l'équipement et au moins un composant connecté à la batterie rechargeable sur la base de la comparaison ; et
si la probabilité est supérieure à un seuil, délivrer un niveau de gravité de l'anomalie dans l'au moins un élément parmi la batterie rechargeable de l'équipement et au moins un composant connecté à la batterie rechargeable,
où le processeur exécutant les instructions lisibles par ordinateur amène en outre l'appareil à :
analyser (730) une plage de fonctionnement normal de l'au moins un élément parmi la batterie rechargeable de l'équipement et l'au moins un composant connecté à la batterie rechargeable ;
calculer (732) une fonction de densité de probabilité, PDF, pour la pluralité de données caractéristiques ;
séparer (734) la pluralité de données caractéristiques, sur la base d'un procédé de classification statistique ; et
créer (736) un modèle d'apprentissage associé aux données apprises correspondant à la pluralité séparée de données caractéristiques.

**12.** Appareil selon la revendication 11, où le processeur exécutant les instructions lisibles par ordinateur amène en outre l'appareil à :

détecter un défaut dans au moins un élément parmi la batterie rechargeable de l'équipement et l'au moins un composant connecté à la batterie rechargeable, sur la base de la détermination d'une anomalie dans les données de mesures paramétriques reçues en analysant un modèle de comportement d'au moins un élément parmi la batterie rechargeable de l'équipement et l'au moins un composant connecté à la batterie rechargeable, sur la base d'au moins un élément parmi un prélèvement anormal de courant, une demande de puissance anormale, un fonctionnement anormal et une résistance de court-circuit ; et
déclencher l'exécution d'au moins une action, sur la base de la détection d'au moins un élément parmi le défaut et le niveau de gravité dans au moins un élément parmi la batterie rechargeable de l'équipement et l'au moins un composant connecté à la batterie rechargeable,
où ladite au moins une action comprend au moins une action parmi éteindre l'équipement, entrer dans un mode d'hibernation, entrer dans un mode d'économie d'énergie et délivrer un message d'urgence.

**13.** Appareil selon la revendication 11, où la pluralité de données caractéristiques comprend au moins un élément parmi une perte d'énergie, $E_L$, entre la charge et la décharge de la batterie rechargeable, une tension aux bornes, Vt, à un état de charge, SOC, fixé au faible niveau de 5%, $V_{min}$, de batterie rechargeable, un temps de phase, Tcv, de Tension Constante, CV, une pente de tension de décharge, Slopev, une valeur maximale de SOC en fin de charge, $SOC_m$, de la batterie rechargeable, un paramètre de pente de premier ordre à partir des paramètres, $P_{param}$, de l'ajustement de la courbe polynomiale, polyfit, Vt vs SOC, une moyenne de la résistance interne estimée pendant la décharge, meanR, de la batterie rechargeable, et une différence de résistance de fin de charge et début de décharge, $\Delta$R, de la batterie rechargeable.

[Fig. 1]

APPARATUS 100 / FUEL GAUGING UNIT 100

┌─ 102 ──────────────┐    ┌─ 108 ──────────────┐
│  PROCESSING        │    │  ADC UNIT          │
│  UNIT              │    │                    │
└────────────────────┘    └────────────────────┘

┌─ 104 ──────────────┐    ┌─ 110 ──────────────┐
│  Memory            │    │  COMMUNICATION     │
│  UNIT              │    │  INTERFACE         │
│  ┌─ 106 ────────┐  │    └────────────────────┘
│  │ PROCESSING   │  │    ┌─ 112 ──────────────┐
│  │ MODULE       │  │    │  VOLTAGE/CURRENT   │
│  └──────────────┘  │    │  SENSE UNIT        │
└────────────────────┘    └────────────────────┘

BATTERY ～101

[Fig. 2]

┌─ 106 ──────────────────────────────────────────────┐
│  PROCESSING MODULE                                 │
│                                                    │
│  ┌─ 202 ──────┐  ┌─ 204 ────────┐  ┌─ 206 ──────┐  │
│  │ DATA       │  │ CHARACTERISTIC│  │ THRESHOLD  │  │
│  │ RECEIVING  │  │ DATA          │  │ VALUE      │  │
│  │ MODULE     │  │ DETERMINATION │  │ COMPARISON │  │
│  │            │  │ MODULE        │  │ MODULE     │  │
│  └────────────┘  └───────────────┘  └────────────┘  │
│                                                    │
│  ┌─ 208 ──────┐                  ┌─ 210 ────────┐  │
│  │ ANALYZING  │                  │ SEVERITY LEVEL│  │
│  │ MODULE     │                  │ OUTPUTTING    │  │
│  │            │                  │ MODULE        │  │
│  └────────────┘                  └───────────────┘  │
└────────────────────────────────────────────────────┘

[Fig. 3]

$V_t$ $I_t$

EXTENDED K ALMAN FILTER

BATTERY RESISTANCE AT
DIFFERENT SOC LEVELS

MEAN OF ESTIMATED RESISTANCE
FROM 0.3 TO 0.8 SOC DURING
DISCHARGE

(END OF CHARGING RESISTANCE) -
(END OF DISCHARGING RESISTANCE)

meanR

ΔR

[Fig. 4]

[Fig. 5A]

```
                                        100

 ┌──────────────────┐      ╱─────────────╲      ┌──────────────┐
 │     INPUTS       │      ╱    FUEL       ╲     │SEVERE FAULT  │
 │(BATTERY CURRENT &│ ───▶ ╲ GAUGING UNIT  ╱ ──▶ │ IDENTIFIED   │
 │    VOLTAGE)      │      ╲─────────────╱       └──────┬───────┘
 └──────────────────┘                                  │
                                                        ▼
        ┌─────────────────────────────────────────────────┐
        │ NOTIFY A USER TO VISIT SERVICE CENTER AS SOON AS  │
        │                  POSSIBLE                         │
        ├─────────────────────────────────────────────────┤
        │ SUGGEST THE USER TO CONNECT THE PHONE TO          │
        │ SPECIFIED ADAPTER AND LEAVE THE                   │
        │ EQUIPMENT/HOST DEVICE IN A SAFE PLACE             │
        ├─────────────────────────────────────────────────┤
        │ TURN OFF THE EQUIPMENT/HOST DEVICE TO PREVENT     │
        │              THERMAL RUNAWAY                       │
        └─────────────────────────────────────────────────┘
```

[Fig. 5B]

```
                                        100

 ┌──────────────────┐      ╱─────────────╲      ┌───────────────┐
 │     INPUTS       │      ╱    FUEL       ╲     │LOW SEVERE FAULT│
 │(BATTERY CURRENT &│ ───▶ ╲ GAUGING UNIT  ╱ ──▶ │  IDENTIFIED    │
 │    VOLTAGE)      │      ╲─────────────╱       └───────┬───────┘
 └──────────────────┘                                   │
                                                         ▼
        ┌─────────────────────────────────────────────────┐
        │   NOTIFY THE USER TO VISIT THE SERVICE CENTER     │
        ├─────────────────────────────────────────────────┤
        │ STORE LOG DATA FOR REFERENCE OF SERVICE CENTER    │
        │    PERSON TO IDENTIFY THE PROBLEM                 │
        └─────────────────────────────────────────────────┘
```

EP 3 676 625 B1

[Fig. 5C]

[Fig. 5D]

[Fig. 6A]

[Fig. 6B]

[Fig. 7A]

700a

```
┌─────────────────────────────────────────────────┐
│        RECEIVE A PARAMETRIC MEASUREMENT DATA FROM AT        │
│  LEAST ONE OF A RE-CHARGEABLE BATTERY OF THE EQUIPMENT      │──702
│         AND AT LEAST ONE COMPONENT CONNECTED               │
│              TO THE RE-CHARGEABLE BATTERY                  │
└─────────────────────────────────────────────────┘
                         │
                         ▼
┌─────────────────────────────────────────────────┐
│   DETERMINE A PLURALITY OF CHARACTERISTIC DATA BASED ON     │──704
│ THE RECEIVED AT LEAST ONE PARAMETRIC MEASUREMENT DATA      │
└─────────────────────────────────────────────────┘
                         │
                         ▼
┌─────────────────────────────────────────────────┐
│      COMPARING A PLURALITY OF CHARACTERISTIC DATA          │
│    WITH A PLURALITY OF THRESHOLD VALUES STORED            │──706
│                    IN A MEMORY                            │
└─────────────────────────────────────────────────┘
                         │
                         ▼
┌─────────────────────────────────────────────────┐
│     ANALYZING RESULTS OF COMPARING THE PLURALITY OF        │
│       THE THRESHOLD VALUES WITH THE PLURALITY OF          │──708
│                  CHARACTERISTIC DATA                      │
└─────────────────────────────────────────────────┘
                         │
                         ▼
┌─────────────────────────────────────────────────┐
│       OUTPUTTING A SEVERITY LEVEL OF THE ANOMALY          │
│        IN THE AT LEAST ONE OF THE RE-CHARGEABLE          │
│    BATTERY OF THE EQUIPMENT AND THE AT LEAST ONE         │
│ COMPONENT CONNECTED TO THE RE-CHARGEABLE BATTERY,        │──710
│          BASED ON THE RESULTS OF COMPARING              │
│     THE PLURALITY OF THE THRESHOLD VALUES WITH          │
│        THE PLURALITY OF CHARACTERISTIC DATA             │
└─────────────────────────────────────────────────┘
```

[Fig. 7B]

700b

DETECT A FAULT IN AT LEAST ONE OF, THE RE-CHARGEABLE BATTERY OF THE EQUIPMENT, THE COMPONENT CONNECTED TO THE RE-CHARGEABLE BATTERY AND A EQUIPMENT, BASED ON DETERMINING AN ABNORMALITY IN THE RECEIVED PARAMETRIC MEASUREMENT DATA BY ANALYZING A BEHAVIOUR PATTERN OF THE AT LEAST ONE OF THE RE-CHARGEABLE BATTERY OF THE EQUIPMENT AND THE AT LEAST ONE COMPONENT CONNECTED TO THE RE-CHARGEABLE BATTERY, BASED ON DETERMINED AT LEAST ONE OF, A DRAWING ABNORMAL CURRENT, AN ABNORMAL POWER DEMAND, THE ABNORMAL OPERATION AND A SHORT CIRCUIT RESISTANCE ⸺722

TRIGGER TO PERFORM AT LEAST ONE ACTION, BASED ON DETECTING AT LEAST ONE OF THE FAULT AND THE SEVERITY LEVEL IN AT LEAST ONE OF, THE RE-CHARGEABLE BATTERY OF THE EQUIPMENT, THE COMPONENT CONNECTED TO THE RE-CHARGEABLE BATTERY AND THE EQUIPMENT ⸺724

[Fig. 7C]

700c

DETERMINE THE PLURALITY OF CHARACTERISTIC DATA BASED ON THE RECEIVED PARAMETRIC MEASUREMENT DATA ⸺728

ANALYZE A NORMAL OPERATION RANGE OF THE AT LEAST ONE OF A RE-CHARGEABLE BATTERY OF THE EQUIPMENT AND THE AT LEAST ONE COMPONENT CONNECTED TO THE RE-CHARGEABLE BATTERY, BASED ON RECEIVING PLURALITY OF THE CHARACTERISTIC DATA IN INITIAL CYCLES ⸺730

CALCULATE A PROBABILITY DENSITY FUNCTION (PDF) FOR THE PLURALITY OF CHARACTERISTIC DATA ⸺732

SEGREGATE THE PLURALITY OF CHARACTERISTIC DATA, BASED ON A STATISTICAL CLASSIFICATION METHOD ⸺734

CREATE A TRAINING MODEL ASSOCIATED WITH THE LEARNED DATA CORRESPONDING TO THE SEGREGATED PLURALITY OF CHARACTERISTIC DATA ⸺736

[Fig. 7D]

700d

OUTPUT AT LEAST ONE SUGGESTION DATA BASED ON
IDENTIFIED SEVERITY LEVEL OF THE FAULT — 742

[Fig. 8]

802

STORAGE UNIT

804

DATABASE

810

APPARATUS 100 /
FUEL GAUGING UNIT
100

DISPLAY
UNIT

101

BATTERY

COMMUNICATION
INTERFACE — 708

810

NETWORK

812

ELECTRONIC DEVICE

814

SERVER

**EP 3 676 625 B1**

**REFERENCES CITED IN THE DESCRIPTION**

**Patent documents cited in the description**

- IN 201741037852
- KR 20160134551 A
- CN 102350951 B
- US 2016231388 A1
- US 2016161542 A1
- US 2012206107 A1